# EUROPÄISCHE PATENTANMELDUNG

(11) **EP 0 731 496 A2**
(43) Veröffentlichungstag der Anmeldung: **11.09.1996**
(21) Anmeldenummer: 96100245.8
(22) Anmeldetag: 10.01.1996
(51) Int. Cl.: H01L 21/306, C23F 1/00

(54) **Verfahren zum plasmalosen Ätzen eines Silicium-Substrats**

(30) Priorität: 22.02.1995 DE 19506118
(71) Anmelder: Forschungszentrum Karlsruhe GmbH, D-76133 Karlsruhe (DE)
(72) Erfinder: Bier, Wilhelm, Dr., D-76344 Eggenstein-Leopoldshafen (DE); Guber, Andreas, Dr., D-76227 Karlsruhe (DE); Köhler, Uwe, D-76297 Stutensee (DE)
(74) Vertreter: Rückert, Friedrich, Dr.

(57) **Zusammenfassung**

Die Erfindung betrifft ein Verfahren zum plasmalosen Ätzen eines Silicium-Substrats, bei dem das Silicium-Substrat in einem abgeschlossenen Raum mit einem gasförmigen Gemisch aus den Elementen Brom und Fluor in Kontakt gebracht wird. Gegenüber dem bekannten Verfahren, bei dem zum Ätzen von Silicium BrF₃ eingesetzt wird, weisen die freigeätzten Oberflächen eine wesentlich verminderte Rauhigkeit auf.

## Beschreibung

Die Erfindung betrifft ein Verfahren zum plasmalosen Ätzen eines Silicium-Substrats gemäß Anspruch 1.

In der Veröffentlichung "Plasmaless dry etching of silicon with fluorine-containing compounds" von D. E. Ibbotson, J. A. Mucha, D. L. Flamm und J. M. Cook, J. Appl. Phys. **56**(10) (1984) 2939-2942 wird eine Reihe von Verbindungen hinsichtlich ihrer Verwendbarkeit zum plasmalosen, selektiven Ätzen von Silicium gegenüber Siliciumdioxid untersucht. Neben XeF₂, das für praktische Anwendungen zu teuer ist, werden die Interhalogenverbindungen ClF₃, BrF₃, BrF₅ und IF₅ vorgeschlagen. Die Versuche wurden mit einem teilweise maskierten n-Typ Si(100)-Wafer durchgeführt, wobei die Interhalogenverbindungen mit Ausnahme von BrF₅ ohne weitere Reinigung eingesetzt wurden. Mit den Interhalogenverbindungen wird eine isotrope Ätzung erzielt, wobei Siliciumdioxid deutlich weniger stark angegriffen wird als bei Plasmaverfahren. BrF₃ gilt als reaktivstes Ätzmittel. Ein weniger geeignetes Ätzmittel ist BrF₅. Wird Silicium bei Raumtemperatur mit den Interhalogenverbindungen geätzt, ergeben sich jedoch rauhe Oberflächen (Abschnitt IV).

In der Veröffentlichung "Plasmaless etching of silicon using chlorine trifluorid" von Y. Saito, O. Yamaoka und A. Yoshida, J. Vac. Sci. Technol. B9(5), (1991), 2503-2506, wird über Versuchsergebnisse zum plasmalosen Ätzen von Silicium berichtet. Das Ätzen wird mit ClF₃ bei einer Temperatur von -20 bis 120 °C und einem Druck von 0,2 bis 8 Torr vorgenommen. Die geätzten Oberflächen sind im allgemeinen rauh. Bei einer Ätztemperatur von -5 °C werden zwar glatte Oberflächen erzielt; bei tiefen Temperaturen vermindert sich jedoch die Ätzgeschwindigkeit und die Versuchsdurchführung wird wegen der erforderlichen Kühlung aufwendiger.

Es ist allgemein bekannt (z. B. Hofmann-Rüdorff, Anorganische Chemie, 19. Aufl., Vieweg-Verlag, Seite 259), daß sich Halogenfluoride durch Reaktion von Fluor mit Chlor, Brom oder Jod bilden. Bromtrifluorid entsteht nach Hofmann-Rüdorff aus Fluor und Bromdampf bei 80 bis 100 °C. Bei höherer Temperatur und Fluorüberschuß entsteht Brompentafluorid.

Der Erfindung liegt die Aufgabe zugrunde, ein Verfahren zum plasmalosen Ätzen eines Silicium-Substrats mit Hilfe von Halogenen vorzuschlagen, bei dem die freigeätzten Flächen des Substrats weniger rauh sind als bei den bekannten Verfahren. Das Verfahren soll sich außerdem einfacher durchführen lassen.

Die Aufgabe wird erfindungsgemäß durch das in Anspruch 1 beschriebene Verfahren gelöst. Vorteilhafte Ausführungsformen des Verfahrens sind in den weiteren Ansprüchen beschrieben.

Überraschenderweise wird bei Silicium-Substraten, die nicht mit der Interhalogenverbindung BrF₃, sondern mit dem Gasgemisch von Brom und Fluor geätzt werden, auf der freigeätzten Substratoberfläche eine deutlich geringere Rauhigkeit (R_{A}) gefunden. Dieses Ergebnis ist insbesondere deshalb unerwartet, weil spektroskopische Untersuchungen gezeigt haben, daß beim erfindungsgemäßen Verfahren intermediär die Bromfluoride BrF und BrF₃ entstehen.

Das erfindungsgemäße Ätzverfahren wird bevorzugt bei Raumtemperatur in einem evakuierbaren Behälter durchgeführt. Das Mischungsverhältnis der Gase Brom und Fluor kann in einem weiten Bereich eingestellt werden. Vorzugsweise wird das Gasgemisch mit einem Partialdruckverhältnis Brom/Fluor von ca. 10 : 1 bis 1 : 10 eigesetzt. Wie spektroskopische Untersuchungen ergeben haben, bildet sich bei Bromüberschuß hauptsächlich die reaktive Interhalogenverbindung BrF. Selbst bei einem Summen-Partialdruck Brom/Fluor von nur 2 mbar und einem Partialdruckverhältnis von 10 : 1 entsteht BrF in ausreichender Menge, so daß Silicium in Kontakt mit dem Gasgemisch innerhalb weniger Minuten zu SiF₄ reagiert. Eine noch schnellere Reaktion ergibt sich, wenn das Partialdruckverhältnis auf ca. 1 : 3 eingestellt wird. Hierbei bildet sich hauptsächlich das sehr reaktive BrF₃. Selbst bei hohem Fluorüberschuß, etwa bei einem Partialdruckverhältnis von weniger als 1 : 4, entsteht in Gegenwart von Silicium nicht das wenig reaktive BrF₅, sondern im wesentlichen BrF₃, so daß die Ätzreaktion mit ausreichender Geschwindigkeit abläuft.

Das Ätzverfahren kann mit guten Ergebnissen bei einem Summen-Partialdruck von Brom und Fluor von 2 bis 100 mbar, besser von 2 bis 50 mbar, durchgeführt werden. Besonders bevorzugt wird ein Summen-Partialdruck von ca. 20 mbar. Höhere Summen-Partialdrücke, etwa bis 200 mbar mit 50 mbar Brom-Partialdruck und 150 mbar Fluor-Partialdruck, können zwar angewendet werden, bieten jedoch keine Vorteile. Bei noch höheren Summen-Partialdrücken von Brom und Fluor besteht die Gefahr eines unkontrollierten Reaktionsablaufes.

In einer ersten Ausführungsform des Verfahrens entspricht der Gesamtdruck in dem Behälter dem Summen-Partialdruck, d. h., das Verfahren wird bei Unterdruck durchgeführt. Die freigeätzte Siliciumoberfläche zeigt jedoch eine besonders geringe Rauhigkeit, wenn gemäß einer zweiten Ausführungsform der Ätzvorgang unter Atmosphärendruck durchgeführt wird. Hierzu wird das Gemisch der Elemente Brom und Fluor durch Einleiten eines Inertgases bis auf Atmosphärendruck verdünnt. Stickstoff oder Argon sind als Inertgas gut geeignet. Die Verminderung der Rauhigkeit gegenüber der ersten Ausführungsform ist mit bloßem Auge deutlich erkennbar.

Beim erfindungsgemäßen Verfahren stellt Brom einen Katalysator dar. In beiden Ausführungsformen wird Silicium nicht zu SiBr₄, sondern zu SiF₄ umgesetzt, so daß Brom nicht verbraucht wird. Die Menge des vorgelegten Broms bleibt während des Ätzverfahrens konstant. Die Bildung von SiBr₄ wäre ohnehin sehr nachteilig, weil SiBr₄ wegen seines niedrigen Dampfdruckes auf dem Substrat auskondensieren und den weiteren Ätzvorgang behindern würde. Die Konstanz der vorgelegten Brommenge eröffnet die Möglichkeit, die Ätzgeschwindigkeit durch Nachdotieren von Fluor zu steuern. Vorzugsweise wird durch Einleiten eines Fluorgasstroms der Fluor-Partialdruck auf einem konstanten Wert gehalten, so daß die Ätzgeschwindigkeit während des Verfahrens konstant bleibt. Alternativ kann der Fluor-Partialdruck während des Ätzvorgangs erhöht werden, wenn die Ätzgeschwindigkeit während des Verfahrens gesteigert werden soll. Wird kein Fluor nachdotiert, sinkt die Ätzgeschwindigkeit infolge des Verbrauchs an Fluor allmählich.

Die Ätzgeschwindigkeit läßt sich zusätzlich erhöhen, wenn in das Gasgemisch Laserlicht eingestrahlt wird. Vorzugsweise wird der Laserstrahl parallel zur der Substratoberfläche justiert.

Das erfindungsgemäße Verfahren läßt sich insbesondere in der Mikrostrukturtechnik einsetzen. Beispielsweise können freitragende Mikrostrukturen aus Kunststoff oder Metall auf einem Substrat erzeugt werden, indem eine darunterliegende Silicium-Schicht durch Abätzen entfernt wird. Auf diese Weise lassen sich Heizwendeln aus Titan oder Gold herstellen. Das erfindungsgemäße Verfahren kann außerdem für ein Opferschichtverfahren mit einem Substrat aus Polysilicium angewendet werden. Eine weitere Einsatzmöglichkeit besteht darin, mit Hilfe von Masken auf der Substratoberfläche unmittelbar Mikrostrukturen aus Silicium mit hervorragender Oberflächenqualität zu erzeugen.

Gegenüber dem Ätzen von Silicium mit BrF₃ bietet das erfindungsgemäße Verfahren eine Reihe von Vorteilen:

Eine Reinigung der einzusetzenden Gase entfällt, da die Gase Brom und Fluor in hoher Reinheit im Handel sind, während die kommerziell angebotenen Interhalogenverbindungen verunreinigt sein können. Von Nachteil ist außerdem der hohe Preis der Interhalogenverbindungen.

Beim erfindungsgemäßen Verfahren bleibt die einmal vorgelegte Brom-Menge konstant; allein über die Fluor-Nachdotierung wird der Ätzprozeß gesteuert. Dabei wird die wirksame Fluorierungsverbindung BrF bzw. BrF₃ bedarfsgerecht gebildet und wieder verbraucht. Beim Ätzen mit BrF₃ steigt dagegen der Brompartialdruck während des Ätzprozesses wegen der Reaktion von BrF₃ mit Silicium an.

Bei Raumtemperatur besitzen die Komponenten des Gasgemisches ausreichend hohe Dampfdrücke (der Dampfdruck von Brom beträgt ca. 240 mbar), um Gasgemische mit nahezu beliebigen Mischungsverhältnissen bei variablem Gesamtdruck herstellen zu können. Im Fall der Verwendung von BrF₃ als Ätzgas ist man bei Raumtemperatur auf einen Partialdruck von ca. 8 mbar beschränkt.

Das Gasgemisch aus Brom und Fluor kann problemlos mit einem Inertgas auf Atmosphärendruck verdünnt werden. Dadurch wird die Handhabung des Verfahrens erleichtert. Außerdem wird die Rauhigkeit der freigeätzten Siliciumoberflächen durch die Verdünnung nochmals deutlich vermindert, so daß sich auf diese Weise ohne weiteres sogar optische Komponenten herstellen lassen. Eine Verdünnung des Ätzgases BrF₃ führt in der Praxis zu Schwierigkeiten, weil BrF₃ bei der Druckerhöhung zunächst auskondensiert und erst allmählich wieder verdampft.

Die Erfindung wird im folgenden anhand von Ausführungsbeispielen näher erläutert.

### Beispiel 1:

### Vergleichsversuche

Mehrere hochglanzpolierte Siliciumwafer mit einer Oberflächenrauhigkeit von R_{A} = 2 nm werden bei Raumtemperatur jeweils 20 µm tief geätzt. In der folgenden Tabelle ist die Rauhigkeit R_{A} der freigeätzten Oberfläche angegeben, die mit verschiedenen Ätzmitteln gefunden wurde.

Ätzmittel Partialdrücke in [mbar] Rauhigkeit R_{A} in [nm]

| | | |
|---|---|---|
| Br₂/F₂/N₂ | 5/15/980 | 4 ± 2 |
| Br₂/F₂ | 5/15 | 15 ± 3 |
| BrF₃ | 6 | 38 ± 5 |
| F₂ | 15 | 143 ± 11 |

Bei Verwendung des bekannten Ätzmittels BrF₃ ergeben sich Rauhigkeitswerte, die um mehr als einen Faktor 2 über den Rauhigkeitswerten liegen, die gemäß der ersten Ausführungsform der Erfindung mit dem Gasgemisch Br₂/F₂ bei einem Gesamtdruck von 20 mbar erhalten werden. Wird das Gasgemisch durch Einleiten von Stickstoff auf Atmosphärendruck verdünnt, lassen sich um eine Größenordnung geringere Rauhigkeitswerte erzielen.

### Beispiel 2:

### Herstellung halbkugeliger Vertiefungen

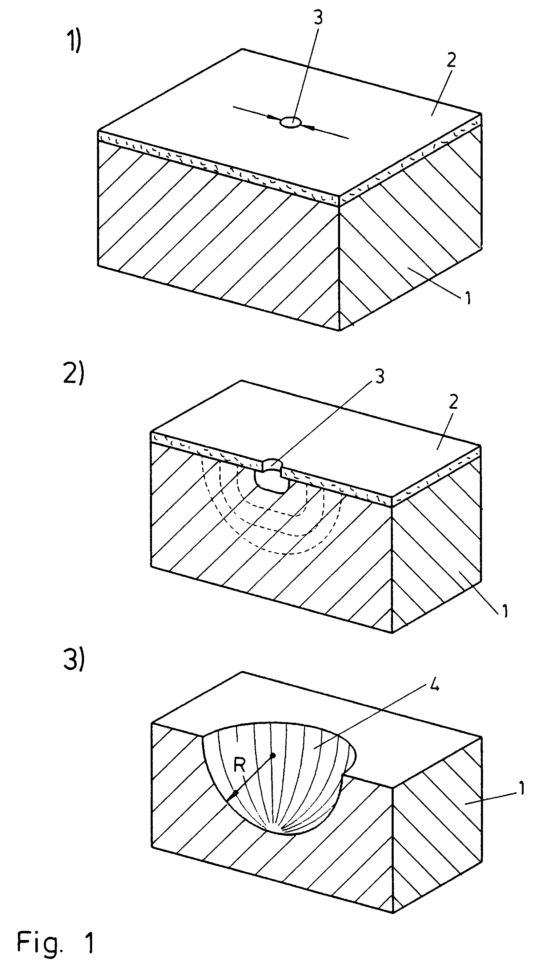

Das Verfahren gemäß Beispiel 2 ist in Fig. 1 dargestellt.

Die Oberfläche eines (100)-Silicium-Wafers 1 wird durch thermische Oxidation oder mit Hilfe eines Bedampfungsverfahrens (CVD-Technik) mit einer etwa 1 µm dicken SiO₂-Schicht 2 überdeckt. Nach den bekannten Methoden der Mikrostrukturtechnik (Herstellung einer Photomaske auf der SiO₂-Schicht 2 und anschließendes Ätzen der freiliegenden Bereiche der SiO₂-Schicht 2) wird die SiO₂-Schicht 2 mit einer Vielzahl kreisrunder Löcher 3 mit Durchmessern 2·Rₒ von etwa 5 bis 20 µm versehen (Fig. 1, Teil 1; in Fig. 1 ist nur ein Loch 3 dargestellt).

Der so präparierte Silicium-Wafer wird in die metallische Küvette eines Infrarot-Spektrometers eingebaut. Nach der Evakuierung werden 5 mbar Brom, 15 mbar Fluor und 980 mbar Stickstoff in die Küvette eingelassen. Durch das entstehende Bromfluorid wird unterhalb der kreisrunden Löchern 3 das Silicium isotrop unter SiF₄-Bildung geätzt (Fig. 1, Teil 2).

Der IR-spektrometrisch bestimmte SiF₄-Partialdruck ist ein Maß für das freigeätzte Siliciumvolumen. Im Bedarfsfall wird eine weitere definierte Fluormenge eingelassen. Wenn der Radius R der infolge des isotropen Ätzvorgangs entstandenen halbkugeligen Vertiefungen den gewünschen Wert von beispielsweise einigen 100 µm erreicht hat, wird das Restgas (Brom, SiF₄ und Stickstoff sowie eventuell F₂-Reste) abgepumpt und anschließend die SiO₂-Schicht in der üblichen Weise mit gepufferter Flußsäure, die Silicium nicht angreift, ebenfalls entfernt.

Die entstandene Siliciumstruktur enthält eine Vielzahl halbkugeliger Vertiefungen (Fig. 1, Teil 3). Sie kann in nachfolgenden Arbeitsgängen beispielsweise als Werkzeug für die Abformung von Mikrolinsen aus Kunststoff oder Glas verwendet werden. Auf diese Weise hergestellte Linsen lassen sich wegen der mit dem erfindungsgemäßen Verfahren erzielbaren glatten Oberfläche in mikrooptischen Anordnungen einsetzen.

### Beispiel 3:

### Herstellung von Unterätzungen für freitragende Titanheizwendeln

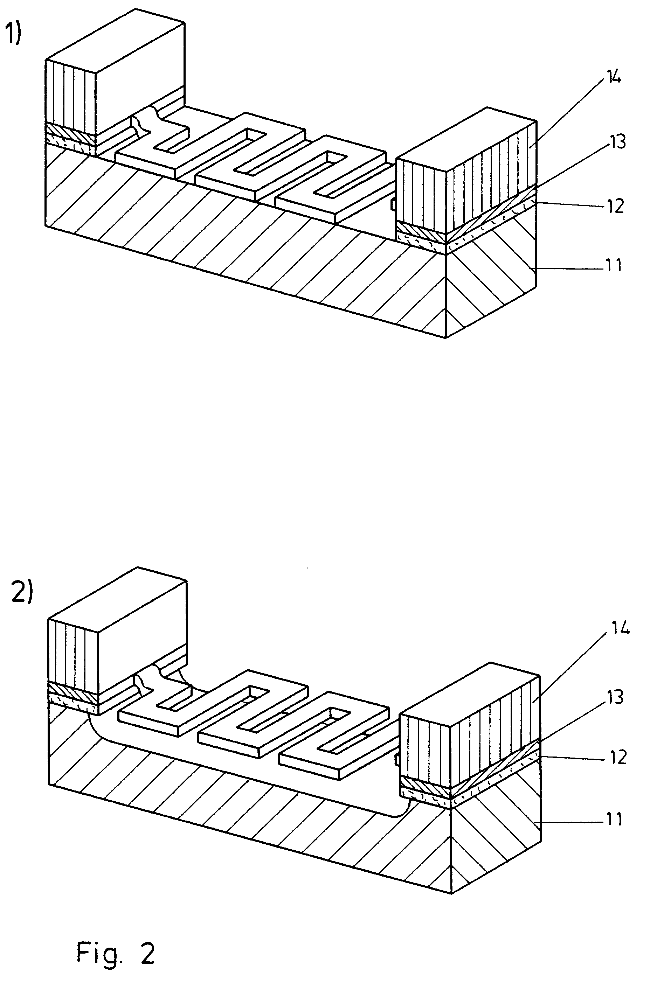

Das Verfahren gemäß Beispiel 3 ist in der Fig. 2 dargestellt.

Zur Herstellung eines Fluidik-Elements soll eine mit den bekannten Methoden der Mikrostrukturtechnik (LIGA-Verfahren) hergestellte Titanheizwendel freigeätzt werden. Die vorgefertigte Mikrostruktur besteht aus einem Silicium-Substrat 11, das teilweise mit einer SiO₂-Schicht 12 überdeckt ist. Auf der SiO₂-Schicht 12 und auf der nicht mit der SiO₂-Schicht 12 überdeckten Silicium-Oberfläche befindet sich eine teilweise strukturierte Titanschicht 13, deren strukturierter Teil die Heizwendel darstellt. Die Titanschicht 13 ist außerhalb des strukturierten Bereichs mit Polymethylmethacrylat (PMMA) 14 abgedeckt (Fig. 2, Teil 1).

Das Freiätzen des strukturierten Teils der Titanschicht 13 gelingt bei Raumtemperatur durch Anwendung eines Gasgemisches aus Brom und Fluor mit Partialdrücken von 5 bzw. 15 mbar. Der entstehende SiF₄-Partialdruck ist ein Maß für die umgesetzte Siliciummenge. Im Bedarfsfall wird Fluor so lange nachdotiert, bis die gewünschte Unterätzung erzielt ist. Bei dem Ätzprozeß werden auch Oberflächen aus PMMA, Titan und Siliciumdioxid dem Ätzgasgemisch ausgesetzt. Dabei erweist es sich als vorteilhaft, daß diese Oberflächen vom Ätzgasgemisch praktisch nicht angegriffen werden.

## Patentansprüche

1. Verfahren zum plasmalosen Ätzen eines Silicium-Substrats, bei dem das Silicium-Substrat in einem abgeschlossenen Raum mit einem gasförmigen Gemisch aus den Elementen Brom und Fluor in Kontakt gebracht wird.

2. Verfahren nach Anspruch 1 mit einem gasförmigen Gemisch, bei dem das Verhältnis der Partialdrücke von Brom und Fluor auf einen Wert zwischen 10 : 1 und 1 : 10 eingestellt ist.

3. Verfahren nach Anspruch 1 oder 2, bei dem die Summe der Partialdrücke von Brom und Fluor zwischen 2 und 100 mbar beträgt.

4. Verfahren nach einem der Ansprüche 1, 2 oder 3 mit einem Verhältnis der Partialdrücke von Brom und Fluor von ca. 1 : 3 und einer Summe der Partialdrücke von Brom und Fluor zwischen 10 und 30 mbar.

5. Verfahren nach Anspruch 3 oder 4 mit einem gasförmigen Gemisch, das mit einem Inertgas auf Atmosphärendruck verdünnt ist.

6. Verfahren nach Anspruch 5 mit Stickstoff oder Argon als Inertgas.

7. Verfahren nach einem der Ansprüche 1 bis 6, bei dem während des Ätzens der Partialdruck von Fluor durch Einleiten eines Fluorgasstroms auf einem vorgegebenen Wert gehalten wird.
